# EUROPEAN PATENT SPECIFICATION

(11) **EP 4 498 100 B1**
(45) Date of publication and mention of the grant of the patent: **23.09.2026**
(21) Application number: 24186343.0
(22) Date of filing: 03.07.2024
(51) Int. Cl.: G01R 22/06, G01R 22/10

(54) **METHOD AND APPARATUS OF DETERMINING BYPASS OF ELECTRICAL METER**
VERFAHREN UND VORRICHTUNG ZUR BESTIMMUNG DER UMLEITUNG EINES ELEKTRISCHEN ZÄHLERS
PROCÉDÉ ET APPAREIL DE DÉTERMINATION DE DÉRIVATION DE COMPTEUR ÉLECTRIQUE

(30) Priority: 28.07.2023 US 202318361209
(43) Date of publication of application: 29.01.2025
(73) Proprietor: Itron, Inc., Liberty Lake, WA 99019 (US)
(72) Inventor: DRISCOLL, Timothy James, Liberty Lake (US); GOPINATHAN, Gopakumar, Liberty Lake (US)
(74) Representative: Finlayson, Scott Henry

(56) References cited:
- EP-B1- 2 503 343
- US-A1- 2009 045 976
- US-A1- 2014 310 138
- US-B2- 11 079 417

## Description

### BACKGROUND

### Field of the Various Embodiments

Various embodiments relate in one aspect to identifying tampered electrical meters and in one more specific aspect, to identifying meters that have been bypassed.

### Description of the Related Art

In general, electric meters are installed at service entrances to premises where electricity is consumed (e.g., houses, stores, and industrial buildings). For a typical house in the U.S., a split, single-phase service (called "split-phase service") includes two supply lines. Power consumed via each supply line can vary independently.

A meter can take regular measurements (samples) of a voltage associated with a supply line (whether for a split-phase service or other service) (e.g. on a source or a load terminal for that supply line), relative to a reference (such as a neutral), and a current flowing between the source terminal and the load terminal for that supply line at the time the voltage was measured. These voltage and current measurements are used in calculating an amount of energy consumed by the premises for that supply line over a period of time ("time period") corresponding to those measurements. With corresponding measurements for other supply line(s), if any, a total energy consumed by loads fed by that service entrance during a measurement interval is calculated. Similar electrical meters are fuse or three-phase service and corresponding measurements of voltage and current on supply lines for each phase of the three-phase service can be obtained by three-phase service meters.

An electrical meter bypass is an electrically conductive material installed between the source terminal and the load terminal that is parallel to the current-measuring instruments in the meter, such that the current flowing in the bypass is not counted as having been consumed by loads on the premises. By installing a bypass, a total measured amount of electrical energy consumed by the premises is less than the amount of energy actually consumed, leading to a lower energy bill for that premises. Electrical meter bypasses can be dangerous and also constitute theft of electrical service. For at least these reasons, electrical utilities seek to detect usage of meter bypasses and take corrective action.

The document EP 2 503 343 B1 describes, in accordance with its abstract, systems, methods, and apparatus for detecting theft and status of electrical power. A method is provided for detecting theft and status of electrical power. The method can include monitoring switch state of a main circuit breaker, monitoring load-side voltage, monitoring load current, determining one or more conditions associated with power usage based at least in part on one or more of the monitored switch state, the monitored load-side voltage, or the monitored load current and transmitting information representing the one or more determined conditions.

### BRIEF DESCRIPTION OF THE DRAWINGS

So that the manner in which the features of the various embodiments can be understood in detail, a description of the invention may be had by reference to various embodiments, some of which are illustrated in the appended drawings. It is to be noted, however, that the appended drawings illustrate only typical embodiments of the invention and are therefore not to be considered limiting of scope in any way, and that there are other equally effective embodiments.
FIG. 1 illustrates an example flow diagram showing a process of determining a possible meter bypass, according to various embodiments;
FIG. 2 illustrates an example flow diagram showing a method for determining a possible meter bypass, according to various embodiments;
FIG. 3 illustrates an example flow diagram of a method for training an inferencing model and using the trained inferencing model to determine a possible meter bypass according to various embodiments;
FIG. 4 illustrates examples of metering metrics for an un-bypassed meter, according to various embodiments;
FIG. 5 illustrates examples of metering metrics for a bypassed meter, according to some embodiments;
FIG. 6 illustrates an example meter installation, according to various embodiments;
FIG. 7 illustrates an example computer with which methods according to various embodiments can be practiced; and
FIG. 8 illustrates aspects of an example utility system 800 according to various embodiments.

### DETAILED DESCRIPTION

An electric meter is installed at a service entrance to a premises (e.g., house, store, or industrial building) to measure an amount of electrical energy consumed by the premises. The electric meter repetitively measures, at measurement intervals (e.g., every second, every other second), a voltage level of and a current flow in the power supplied by the electric service. Energy can be supplied to a load connected between any of the supply lines and the neutral and also to a load connected between two or more supply lines. In a three-phase power service, three supply lines have respective voltage signals and the three-phase service may or may not have a neutral, and loads can be connected between and/or among these supply lines and/or the neutral in various ways.

In some embodiments herein, current flow during delivery of power to a premises via supply lines of an electrical service is measured, whether the supply lines are for a split-phase service, three-phase service, or another kind of service. Electric meters are capable of repetitively collecting and storing current and voltage measurements for these supply lines for a period time (a reporting interval) and then communicating the current and voltage measurements collected during that reporting interval for receipt by a central controller. These voltage and current measurements are used in calculating energy consumed by the premises. A bypass installed in an electrical meter creates a parallel path for one or more of the supply lines around the current sensing element for that supply line into the premises, and results in undermeasurement of energy delivered to the premises as well as posing a safety hazard.

Existing approaches to detecting such bypasses include inspecting meters for signs of intrusion (e.g., if a lock or a seal is broken), and/or comparing measured amounts of energy consumed by a premises relative to that consumed by other premises. The first approach is labor-intensive by requiring personnel to visually inspect meters, and even if a meter is inspected at a given time, a bypass could be installed immediately after and not detected until a next inspection. Comparing measured amounts of energy among different premises fails to account for legitimate differences in how much energy is consumed by different premises. Therefore, continued improvements in detecting electrical meter bypass are desired.

In order to address these shortcomings, techniques are disclosed herein that determine whether measured data from a meter is indicative of a bypass on that meter. In one embodiment, a computing device obtains a count of load switching events at a location over a period of time. A load switching event corresponds to a change in current flow (and corresponding change in amount of energy consumption) in one or more supply lines to the meter. A load switching event can be detected by identifying a change in current flow greater than a threshold in one or more supply lines to the meter at the location. The computing device also obtains a measure of electricity consumption for the location over the period of time. The computing device determines that the meter has likely been bypassed, based on the count of the load switching events and the measured amount of electrical consumption.

At least one technical advantage of the disclosed techniques is that, with the disclosed techniques, the possible existence of a bypass on an electrical meter can be determined or inferred based on data that is already collected for purposes of measuring electrical energy consumption and corresponding billing. In addition, as more data is collected and as feedback is obtained as to the accuracy of the meter bypass inferences, the accuracy of the determinations and/or inferences can be improved. The disclosed techniques further reduce the need for random or systemic meter audits or other visual inspections and are also less intrusive to utility customers.

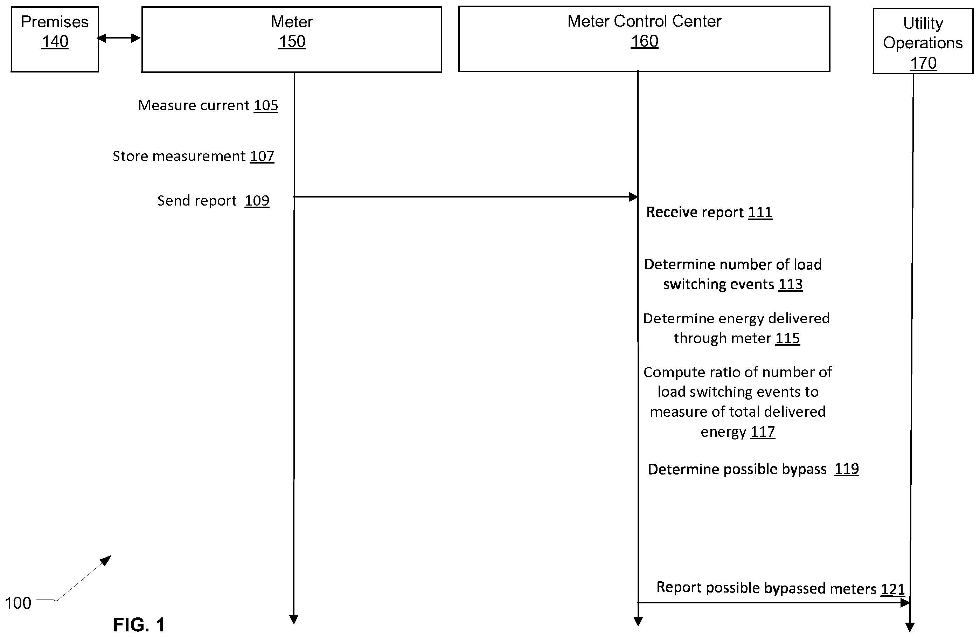

FIG. 1 illustrates an example flow diagram showing a process 100 of determining a possible meter bypass, according to various embodiments. Although the interactions between the elements performing process 100 are shown in an order, persons skilled in the art will understand that the interactions can be performed in a different order, interactions can be repeated or skipped, and/or can be performed by components other than those described in FIG. 1. As shown in FIG. 1, process 100 involves various operations performed by, without limitation, a meter control center 160, a utility operations 170, a meter 150, and premises 140. Utility operations 170 represents back office operations of a utility, such as billing operations and/or field service scheduling. Utility operations 170, meter control center 160, and meter 150 communicate via one or more network(s) (not depicted). As shown, meter 150 communicates with meter control center 160, and meter control center 160 communicates with utility operations 170. Utility operations 170 communicates with components within electricity delivery infrastructure that include components involved in electricity generation and distribution and which ultimately connect to meter 150 for delivery of electrical energy to premises 140 through meter 150. Data communications among the depicted elements can be implemented by any technically feasible combination of communication infrastructure that enables communications according to the embodiments described herein.

As shown, process 100 begins at step 105, where meter 150 measures, at measurement intervals, voltage and current for each supply line in the service provided by meter 150 to premises 140. In some embodiments, the measurement interval is selectable by meter control center 160. Example measurement intervals range from a fraction of a second to multiple seconds and can also include larger intervals. The measurement intervals occur during a reporting interval. In some embodiments, a reporting interval is one day, and in other embodiments, the reporting interval is six, twelve hours, or some other duration including multiple measurement intervals. In some embodiments, the reporting interval is selectable by meter control center 160. The current measurement at step 105 does not measure current flowing in a bypass, should one exist. Therefore, a bypassed meter would not measure at step 105 all the current delivered to premises 140 via meter 150 and would thus not capture measurements indicating all of the electricity consumption by premises 140. Meter 150 can obtain these current and optional voltage measurements in accordance with any suitable metering operation of meter 150.

At step 107, meter 150 stores the measurements obtained during a reporting interval in local storage. A resolution at which the measurements are stored can vary among embodiments. Where these measurements are used for billing purposes, these measurements are stored at a resolution selected for sufficient billing accuracy. Storing the measurements allows meter 150 to communicate less frequently with meter control center 160 and also allows preprocessing of the stored measurements in some embodiments. Some embodiments have local storage of meter 150 sized to allow storage of at least the measurements taken at step 105 for one or more reporting intervals. The steps 105 and 107 are repetitively performed, at the measurement interval, during each reporting interval.

At step 109, meter 150 sends a report, via a network, based on the stored measurements for that reporting interval to meter control center 160. In some embodiments, the report is also usable for billing purposes and data in that report are reused to implement the disclosed embodiments. In other embodiments, the report contains only data or measurements used for embodiments according to the disclosure. For example, in some embodiments, actual measured voltage values are not used, and these values do not need to be reported according to these embodiments. The report also can have a summarization of the measurements or other preprocessing, consistent with disclosed embodiments. Meter 150 continues measuring current samples at step 105 (and optionally voltage) and storing at step 107 those measured current samples for a subsequent reporting interval while preparing to send and sending the report, at step 109, for a then-completed reporting interval.

At step 111, meter control center 160 receives the report via a network interface to the network (not depicted). At step 113, meter control center 160 determines a number of load switching events that occurred during the reporting interval. In one embodiment, a load switching event is defined as two or more measurement intervals where a measured current changed by more than a threshold amount between those two or more measurement intervals. The threshold amount can be set at a high enough level to reduce a possibility of mistaking current changes due to noise and/or measurement error with current changes due to load switching events, but not at a level so high as to miss too many load switching events. In some embodiments, a load switching event is counted when a measured current through a metered supply line changes by more 10 milliamps (mA) from one measurement interval to another. Some embodiments detect a current change of at least the threshold and require that current change to be maintained (i.e., not revert back to a prior level) for a number of measurement intervals in order to count a load switching event. In various embodiments, this number of measurement intervals may be adjusted (e.g., by a human operator and/or via a machine learning algorithm) to improve detection accuracy. The identified load switching events can be counted for an entirety of the reporting interval or for one or more portions thereof. For example, a statistically relevant sampling of the measurements in a reporting interval can be used. In some embodiments, the determination of a number of load switching events comprises computing the number of load switches events, at least by maintaining a running sum of the load switching events detected.

At step 115, meter control center 160 determines a measure of total energy delivered through meter 150. In some embodiments, the measure of total energy delivered is for the entirety of the reporting interval. In some embodiments, the measure of total energy delivered is for a portion of the reporting interval. In these embodiments, the portion of the reporting interval over which total energy delivered is measured corresponds, at least to some extent, to the portion of the reporting interval for which load switching events were counted. If an embodiment uses only a portion or portions of a reporting interval, the portion is fixed between reporting intervals for some embodiments and in other embodiments, varies between reporting intervals.

At step 117, a Switching Event to measured Total Energy delivered Ratio (SETER) metric is computed, and which relates a number of load switching events to the measure of total delivered energy via meter control center 160. In one embodiment, the SETER metric is computed by dividing the total number of load switching events over the reporting interval by a measured total energy delivered for the entire reporting interval. Other embodiments provide that the SETER metric is calculated for load switching events and measured total energy for a portion of the reporting interval. The SETER metric is one way to characterize a relationship between the number of load switching events and the measured total energy delivered. It would be appreciated that there are other ways to represent or characterize this relationship. For example, the SETER metric can be formed as an inverse by dividing the measured total energy delivered by the total number of load switching events. Scaling of the number of load switching events and/or the measured total energy delivered also can be done in some embodiments. For example, one or more inputs to a metric, such as the number of load switching events and/or the measure of total energy delivered, which are inputs for calculating the SETER metric, can be scaled by a constant, without affecting usability of the SETER metric to indicate a proportion of the number of load switching events relative to the measure of total energy delivered.

At step 119, a determination is made as to whether meter 150 is possibly bypassed based at least on the SETER metric calculated at 117. In an embodiment, the SETER metric is compared with a variety of other data. Such other data can include but is not limited to other SETER metrics for meter 150 pertaining to other reporting intervals, and SETER metrics produced for other meters, as explained in more detail below. If these comparisons or other analysis show that meter 150 has a comparatively high SETER metric, then a determination that the meter is potentially bypassed can be made, because the SETER metric for meter 150 is considered abnormal relative to typically expected SETER metrics. As will be explained below, other factors can be used to characterize what is and is not an abnormal SETER metric, and filtering mechanisms can be employed to reduce false positives (i.e., flagging a meter as being bypassed when it is not). These comparisons and/or characterizations can be made explicitly, statistically and/or inferentially in various embodiments, as explained below.

At step 121, meter control center 160 reports meter 150, in response to the determination at step 119 resulting in a bypassed determination, to utility operations 170 as likely bypassed (relative to other meters). Other information can be provided to utility operations 170, such as total measured energy consumption, peak loading and other information that can be used for billing or other purposes. Utility operations 170 can then choose whether to conduct an inspection of meter 150 to confirm or refute that meter 150 is bypassed, or take some other action. Some embodiments provide a report for each meter with a probability of bypass. Some embodiments provide a report that ranks a meter in a percentile probability of being bypassed relative to other meters served by utility operations 170. In some embodiments, a report for all meters served by utility operations 170 is provided and which includes a probability of bypass for each meter or a ranking of bypass probability among the meters.

Although not shown, steps 105-109 are performed by each meter served by utility operations 170 in some embodiments. In some embodiments, a utility can choose to monitor a subset of meters on a fixed or rotating basis for bypass, or can choose to monitor meters for premises where a bypass was detected previously. In some embodiments, steps 111-121 are performed for each report received from a meter and in other embodiments, steps 111-121 are performed for a sampling or selection of the reports.

As discussed above and further emphasized here, FIG. 1 is merely an example which should not unduly limit the scope of the claims. One of ordinary skill in the art would recognize many variations, alternatives, and modifications. In some embodiments, while certain elements were identified separately in FIG. 1, separateness is not required in the embodiments. For example, meter control center 160 can be part of utility operations 170 or vice versa. Conversely, multiple meter control centers and utility operations can be provided, and these elements can interact in any technically feasible combination to implement the embodiments disclosed herein. Multiple computers at meter control center 160 can perform steps 111-121 using data from different meters 150. Some portions of process 100 can be performed on meter 150 itself, as described below in more detail. It also would be appreciated that some portions of process 100 can be performed in connection with other processes, or data generated by some portions of process 100 can already be available for use. In such situations, data generated in those other processes or otherwise already available can be obtained, rather than computed. For example, a measure of total energy delivered for a reporting interval can be produced for billing purposes, and if so, then that measure of total energy delivered can be used at step 115, rather than again computing that measure of total energy delivered. It also would be appreciated that technical variations to the disclosed embodiments can be provided, and examples of some such variations are described below.

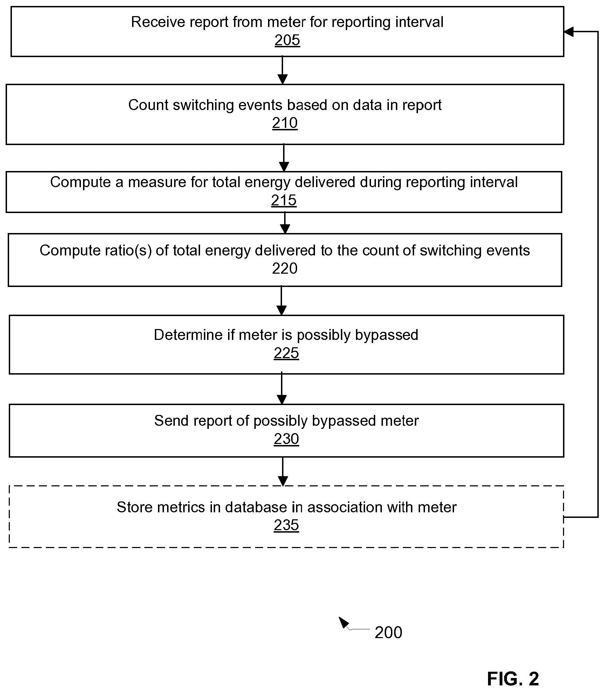

FIG. 2 illustrates an example flow diagram of method steps for a method 200 for determining a possible meter bypass, according to various embodiments. Although the method steps are described as being performed by meter control center 160, other computing devices in one or more other systems, such as a distributed computing system can perform the method steps and meter control center 160 itself can contain various computers that collectively perform method 300. In various embodiments, some or all of the functions ascribed to meter control center 160 can be performed by meter 150 itself. In some embodiments, meter control center 160 is implemented as a distributed system. In some of such embodiments, a network of meters implements the functions of meter control center 160 collectively and/or meter control center 160 is implemented on an edge computing platform in a network (e.g., in a 5G edge computing platform disposed on a cellular tower). Furthermore, although the method steps are shown in an order, persons skilled in the art will understand that some method steps can be performed in a different order, repeated, and/or performed by components other than those described in FIG. 2.

At step 205, a report is received by meter control center 160 from meter 150 for a reporting interval. The report includes samples of at least current information, and optionally voltage information. Samples of current and/or voltage can be taken in any technically feasible approach, including approaches commonly used in electric meters. The samples are taken at measurement intervals during the reporting interval. The measurement interval can be, for example, one second, such that a sample of current is taken every second of a reporting interval. The reporting interval can be, for example, a day, any portion of a day, or a multi-day period. In some embodiments, the samples at step 205 are taken for purposes of billing and also used according to embodiments of the disclosure. In other embodiments, the measurements at step 105 are for use according to the disclosure and other measurements are taken for billing purposes. A choice of measurement interval and reporting interval can be based on considerations including capabilities of a meter generating the report, balancing measurement interval and reporting interval duration, on operational considerations, regulatory considerations, business management considerations, or any combination thereof.

At step 210, a total count of load switching events is generated or otherwise obtained based on identifying differences of current flow greater than a threshold in the sample data provided in the report. A difference in current flow can be measured as a difference in magnitude of current flow. In one embodiment, a change greater than 10 mA in magnitude of current flow is indicative of a load switching event. For example, for a first sample, a current magnitude is measured as 1.00 Amperes, and for a second sample, a current magnitude is measured at 1.015 Amperes, which is a 15 mA difference, so that a load switching event would be considered to have occurred between the first sample and the second sample.

A choice of minimum current change to count a load switching event can be made based on a measurement noise floor for meter 150, with some additional buffer. For example, a 10 mA current difference is appropriate for a 6mA noise floor, but other current difference amounts can be used in different embodiments. A choice of minimum current change can be based on considerations other than a noise floor of the meter that obtained the measurements. For example, some embodiments can reliably determine (including detecting or otherwise inferring) a likelihood of meter bypass based on counting only a portion of load switching events that have larger current differences, and in these embodiments, a lower threshold can result in counting more valid load switching events. Some embodiments require a detected change in current to at least be maintained for several measurement intervals in order to count a load switching event. Stated differently, if electrical service at meter 150 can have large noise-induced current spikes, then a difference in current between a first and a second current sample can be pushed over the minimum current change by a noise spike, which would subside by a subsequent sample (e.g., a third or fourth sample), but a change in current attributable to an actual load switching event would persist during these subsequent samples. Different threshold comparisons for different sample comparisons can be used, such as 10 mA between two adjacent measurement intervals, and/or a larger change in current between two measurement intervals that have one or more intervening measurement intervals, and combinations of these approaches. As the foregoing illustrates, a variety of current and/or voltage sampling approaches can be provided in different embodiments according to the disclosure.

In some embodiments, a largest current through one or more supply lines is tracked for the reporting interval. The largest current can be identified while identifying load switching events by comparing a measured current for a measurement interval with a then-largest recorded current and if the measured current is larger, replacing the then-largest recorded current with the measured current as the new largest recorded current. In these embodiments, a sum of the largest currents, such as for both supply lines of a split-phase residential service, can also be tracked. These largest currents are used in some embodiments as described below.

At step 215, a total measured energy delivered is computed based on the sample data. For example, a measured energy delivered on each supply line, for each measurement interval, can be determined by multiplying the sampled voltage with the sampled current to obtain power (Watts). It is then assumed that the power delivered is constant for the measurement interval, to obtain the measure of energy delivered in that interval (essentially, a piece-wise integration). For a one-second interval, that energy figure would be in Watt-seconds. By summing 3600 of the intervals (60 seconds per minute and 60 minutes per hour), a Watt-hour calculation is obtained, which can in turn be simplified by converting into kilowatt-hour form by dividing by 1000.

It would be understood, however, that other implementations can be provided. For example, in some embodiments, because a voltage level for electrical service is expected to be within a range of a specified nominal value, the voltage level can be modeled as a constant for energy consumption calculations used for the purpose of determining whether a meter is bypassed, even though for billing purposes, an actual sampled voltage can be used to calculate total energy consumption. Still further, in some embodiments, if a voltage level is modeled as a constant, rather than calculating a measure of energy delivered, such as by performing the multiplications and summations described above, a sum of currents also can be considered a measure of energy delivered in embodiments of the disclosure. As would be appreciated from this disclosure, the computation at step 215 produces an indication or a measure that describes and/or is correlated to energy delivered, but such measure or indication does not need to be strictly in accordance with or represent actual energy delivered, or even be in units of energy. A precision used in calculating and/or representing the total energy consumption also can be less than a precision used for billing purposes. Therefore, some embodiments round current measurements to lessen storage and/or computation requirements.

At step 220, a SETER metric is computed. In one embodiment, the SETER metric is computed by dividing the total number of load switching events over the reporting interval by a measured total energy for the reporting interval. Other embodiments provide that the SETER metric is calculated for load switching events and measured total energy for a portion of the reporting interval. The SETER metric is one way to characterize a relationship between the number of load switching events and the measured total energy. It would be appreciated that there are other ways to represent or characterize such relationship. For example, an inverse ratio can be formed by dividing the measured total energy by the total number of load switching events. Other examples include taking a logarithm of the number of load switching events and then dividing by energy delivered, scaling one or more of the number of load switching events and the measured total energy by another number, and so on. As would be appreciated, embodiments provide one or more mechanisms to characterize a relationship between the number of load switching events and the measured total energy and then detect an abnormality or outliers in that characterization, which results in a determination that meter 150 is likely bypassed. As described above, some embodiments do not calculate an actual total energy delivered, and can use a constant voltage, or simply a sum of measured currents; in these embodiments, the SETER metric can be formed with those representations of energy delivered as well. Some embodiments also, or instead, compute a ratio between the total count of load Switching Events during a reporting interval to the sum of Largest Currents (SELC metric) during that reporting interval, which relates the total count of load switching events to the sum of largest currents detected during a reporting interval. A high (relative to a comparison with SELC metrics from other meters and/or SELC metrics from prior reporting intervals for meter 150) also is an indicator or otherwise predicts that meter 150 is more likely to be bypassed.

At step 225, based at least on the SETER metric, the meter is determined as likely being bypassed or not. As a particular example, if the SETER metric is high relative to a comparison value, then the meter is determined as likely bypassed. Different embodiments use different approaches to determining the comparison value and what is determined to be high relative to the comparison value. In some embodiments, the comparison value is a numerical threshold, derived based on data from a sample of meters. The sample of meters can be assembled based on similar size and geographical location of premises served through the meters. In some embodiments, the comparison value is a threshold derived from or otherwise based on historical data from the same meter. The comparison value can be based on empirical analysis of behavior of meters that were found to be bypassed, and those that are known to not be bypassed. Some embodiments use multiple comparisons that include two or more of the above embodiments. In some embodiments, rather than a specific comparison with a value, the meters are sorted based on their SETER metric and/or SELC metrics, and meters with highest SETER metrics and/or SELC metrics are characterized as likely bypassed. A percentile can be set as a cutoff for what meters are characterized as likely bypassed, such as the top 1%, 5%, or 10%. This cutoff can be set based on a quality of the input data. In other words, if the sample set of meter outputs are more similar, except for possible presence of a bypass, then the distribution of the SETER metric is expected to be tighter around a mean, and the cutoff can be set to a higher percentage. The cutoff also can be set based on other considerations, such as resources available to investigate possibly bypassed meters.

In some embodiments, other metrics or indicia are also usable to characterize a likelihood or probability that a meter is bypassed, in addition to the SETER metric. One such metric is a Total Measured Energy Delivered (TMED metric). In some embodiments, in addition to the SETER metric being high relative to one or more comparisons, or otherwise abnormal, the TMED metric must be over a minimum delivered energy threshold. The minimum delivered energy threshold can be set based on a variety of factors, including to exclude unoccupied homes where electrical consumption is low, which would cause the SETER metric to become abnormally high by dividing an otherwise normal switching event count by an energy delivered number. In some embodiments, the SETER metric and the SELC metric are used together, and where both are high relative to respective comparisons, a meter is characterized as likely bypassed. In some embodiments, the SETER metric and the SELC metric are used along with requiring the TMED metric to be greater than a threshold.

Another metric that can be used in some embodiments is variation (variability) of the total count of load switching events across multiple reporting intervals. Variability of total count of load switching events can be measured using a standard deviation of counts of load switching events for meter 150 over a plurality of reporting intervals, such as for a week or a month. If this variability is high relative to a baseline (such as an average of standard deviations from a plurality of meters and/or historical standard deviations for a plurality of reporting intervals from meter 150 itself), then meter 150 is determined to more likely be bypassed. This metric also can be used to further validate determinations based on one or more of the SETER metric and the SELC metric.

In different embodiments, smoothing and/or averaging techniques are applied to the various metrics disclosed. For example, certain metrics and/or values used in those metrics are calculated using data from multiple reporting intervals and can be based on a moving average (such as a 7-day, 10-day or 14-day moving average). Calculations can be based on samples from different-length timeframes and averages of these values over different-length timeframes. Refinements to these comparisons and models can be made as more data is gathered on bypassed meter behavior. In some embodiments, additional or different metrics are used in response to identifying characteristic behavior of different kinds of meter bypasses. In some embodiments, the determination at step 225 uses a statistical analysis and/or an inferencing model trained on examples of what is considered abnormally high and what is not.

As can be understood, some embodiments establish one or more expectations that relate counts of load switching events to measured energy consumption (e.g., the SETER metric) and then identify meters that are reporting values different than the one or more expectations. The identification of these meters can be qualified or filtered based on other metrics or criteria. These expectations can be based on one or more of counts obtained for the same meter over a plurality of reporting intervals and/or counts obtained for different meters over one or more reporting intervals. These expectations also can be based on other metrics, such as peak measured current for the same meter over multiple periods of time, and/or for different meters over one or more periods of time. These expectations can be expressed as an average or median of what is expected for an un-bypassed meter, or a distribution that expresses a probability of a given meter reporting a given dataset without being bypassed.

A sensitivity to an amount of deviation from an expectation for meter metrics to cause a determination that a meter is likely bypassed can be adjusted, such as based on what data was used to form the expectation. For example, the data used to establish the expectation can be selected so that the data is for a group of premises that have reasonably similar circumstances. In other approaches, a broader, less homogeneous dataset can be used. As between these examples, if an expectation for what is normal is established for a comparatively less homogenous dataset, then a larger dispersion for metrics can be realized, and appropriate adjustments to criteria for characterizing a meter as bypassed can be made. In sum, criteria for meter results likely to indicate a bypass can be tuned to characteristics of a dataset being used and for a desired sensitivity; these criteria can be revised over time, including based on feedback concerning accuracy of the determinations. The expectations do not need to be explicitly expressed but can be implicit in a trained inferencing model that was fitted to a dataset containing metrics according to this disclosure. It would be understood that these example embodiments are not by way of excluding other embodiments according to the disclosure.

At step 230, if the meter was determined as likely being bypassed, then a report is sent to utility operations 170. Other information can be provided to utility operations 170 with the report, such as the SETER, SELC and/or TMED metrics, peak loading and other information that can be used for billing or other purposes. Some embodiments provide a report for each meter that provides a determined probability of bypass existence. Some embodiments provide a report that ranks a meter in a percentile probability of being bypassed relative to other meters served by utility operations 170. In some embodiments, a report for all meters served by utility operations 170 is provided and this report includes an indicator for meters likely bypassed, a probability of bypass, a percentile likelihood of bypass, and/or a ranking among the meters for probability of bypass. Utility operations 170 can determine what information is provided about meters likely to be bypassed, and a format of such information. The report can be made by updating data in a database accessible by utility operations 170, such as in embodiments where meter control center 160 and utility operations 170 are part of one operations and control center (that can be distributed across sites and/or implemented by many separate computers). Utility operations 170 also can pull the report on demand from a data source, which can be identified by a uniform resource identifier. The report can be effected by providing the reported data to a data analysis tool that can be cloud-based and accessible by utility operations 170. Any combination of the foregoing reporting methodologies can be implemented. Utility operations 170 can then choose whether to conduct an inspection of meter 150 to confirm or refute that meter 150 is bypassed, or take some other action.

At step 235, the metrics calculated at steps 210, 215, and 220 (or any portion thereof) can be stored in a database in association with an identifier for the meter that generated the report. Some embodiments use the stored metrics to update thresholds or other comparisons for use in analyzing future meter reports, from meter 150 and/or other meters. Method 200 returns to step 205 to receive another report, which can come from meter 150 or another meter. In some embodiments, method 200 is performed for each report received from each meter. In some embodiments, method 200 is performed for a subset of reports received from a meter; for example, every other or every third report. Method 200 can be performed on different subsets of meter reports for different meters. Some embodiments perform method 200 for a first subset of reports, and determine if a second subset of reports should be processed based on results of processing the first subset of reports, such as to increase confidence in a determination whether meter 150 is bypassed or not. In embodiments where only a subset of reports are processed, storage of metrics at step 235 includes storing further data that describes which reports were used to produce the metrics, so that other processing and any statistics created from those metrics are accurate. A plurality of reports can be processed in parallel from meter 150 and/or other meters.

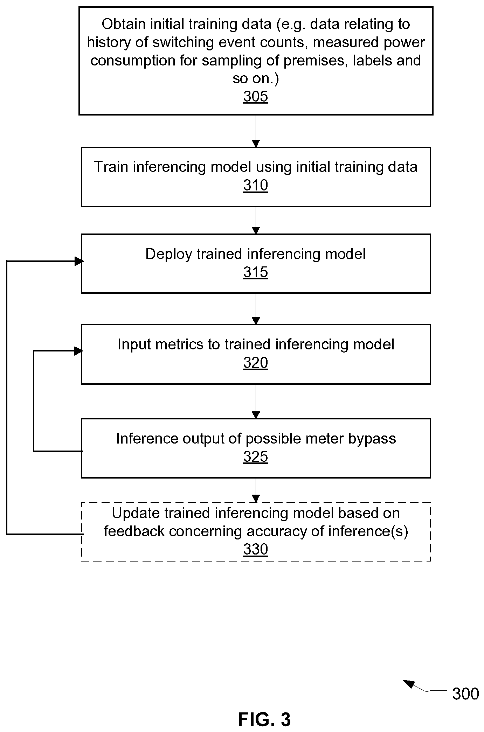

FIG. 3 illustrates an example flow diagram of a method 300 for training an inferencing model and using the trained inferencing model to determine a possible meter bypass according to various embodiments. Although the method steps in method 300 are described as being performed by meter control center 160, other computing devices in one or more other systems, such as a distributed computing system can perform the method steps, and meter control center 160 itself can contain various computers that collectively perform method 300. Although the interactions between the elements performing in method 300 are shown in an order, persons skilled in the art will understand that the interactions can be performed in a different order, interactions can be repeated or skipped, and/or can be performed by components other than those described in FIG. 3.

At step 305, initial training data is obtained (such as information for metrics as described above, labels associated with these metrics (individually and/or in groups) that associate the metrics with bypassed or un-bypassed meters, and/or data concerning expectations for these metrics. While examples of these metrics (e.g., SETER, SELC and TMED metrics) are disclosed herein, other variations thereon are within the scope of the disclosure.

In some embodiments, during a training portion, initial training data is used to train an untrained inferencing model. An untrained inferencing model can have multiple neural network layers, each with a plurality of neurons. The neurons within each layer have interconnections for which weights can be determined through training. The neural network layers of the inferencing model are interconnected, such as in a predetermined order (e.g., input, hidden and output layers). Interconnections between any of the layers are weighted, and these weights are determined through training. At step 310, training can include determining a combination of interconnections and weights among neurons within layers and interconnections between layers to cause the inferencing model to output inferences consistent with the initial training data. Some embodiments use an inferencing model that is based on decision-tree machine learning models. Decision trees in these embodiments can include decisions based on metrics disclosed herein, and these embodiments can use gradient boosting algorithms to train the inferencing model. Training step 310 can include revisions to the inferencing model itself, such as adding neurons, adding layers, deleting neurons and/or deleting layers.

Training at step 310 can include training multiple different inferencing models targeted to different accuracy and computation capabilities. In some embodiments, training includes training one inferencing model and then pruning and/or quantizing that trained inferencing model to create an inferencing model with reduced computation and/or memory requirements. For example, a more complex and more accurate inferencing model can be trained for deployment at meter control center 160 while a less computationally intensive inferencing model can be trained or derived from the more complex inferencing model, for deployment at meter 150. In each case, an inferencing model can be designed according to a target amount of computation resources available or allocatable to execute the inferencing model.

At step 315, upon satisfactory training, the trained inferencing model can be deployed for use in meter control center 160. Deployment at step 315 can include providing information descriptive of the trained inferencing model to one or more computers at meter control center 160 that can access or produce metrics that are inputs to the trained inferencing model. In some embodiments, deployment at step 315 includes establishing a virtual machine instance that functions as an inferencing engine executing on a set of computation resources, which has, without limitation, connections to a database that contains metrics used as inputs to the trained inferencing model. Some embodiments include that deployment of the trained inferencing model at step 315 includes deploying a trained inferencing model to meter 150. In these embodiments, deployment includes transmitting information descriptive of the trained inferencing model via a network to meter 150, which receives the information and loads the trained inferencing model into computation resources in meter 150.

At step 320, metrics (e.g., the SETER metric and/or the SELC metric) corresponding to a particular meter (and consistent with metrics on which the inferencing model(s) were trained) are inputted to an inferencing engine, which includes at least computation resources configured with the trained inferencing model (e.g. 410 below)

At step 325, output(s) are received from the inferencing engine indicative of an inference as to whether the metrics for that particular meter are likely to correspond to a bypassed meter or an un-bypassed meter, which results in a determination of likelihood of bypass existence. These outputs can be tested, including by inspecting meters identified as being potentially bypassed.

At step 330, further training or updating of the model is performed, such as based on results of such inspections and based on metrics derived from further reported data. In some embodiments, updating is performed in response to availability of feedback from meter inspections, and in these embodiments, step 330 would occur infrequently compared with step 325. After updating the trained inferencing model, the updated model can be deployed for use at step 315.

Some embodiments maintain or deploy multiple trained models at a given time, such that step 320 and step 325 are performed for each currently deployed model. The inference outputs from each trained model can be compared for consistency, and/or combined to output a blended inference. Different meters can be associated with different trained models and a given meter can be associated with multiple models (e.g., for a given reporting interval, different trained models are used for different meters and/or multiple models are used for one meter). Over time, the model(s) can be revised to include other metrics, and/or remove metrics as input. In some examples, a baseline trained model that is used as a starting point can be created, and then adapted for specific circumstances, such as a particular geographic region or as requested by a particular utility, and so on.

In embodiments where a trained inferencing model is deployed to meter 150, meter 150 performs step 320, step 325, and optionally step 330 of method 300. In such embodiments, meter 150 reports the inference output of step 325 to meter control center 160. Meter 150 can perform steps 320 and 325 on a schedule, such as daily, weekly, or monthly based on inputted metrics from a prior period, which can be selectable. For example, the metrics can be for a prior day, week and/or month. In some embodiments, meter 150 continues to transmit reports to meter control center 160 that contain current and/or voltage measurements taken at regular intervals during reporting period(s) (as described with respect to FIG. 1 and FIG. 2), in addition to any determinations or inference outputs generated at meter 150. In other embodiments, meter 150 sends determinations or inference outputs as to likelihood of meter 150 being bypassed to meter control center 160, and metrics calculated by meter 150 (such as a total count of load switching events and/or sum of maximum currents for a reporting interval). Meter 150 can also report data for billing purposes.

In other embodiments, an unsupervised machine learning approach can be used. In an unsupervised machine learning approach, metrics generated from a set of meters, including meter 150, will be inputted to a machine learning model that uses the metrics for the set of meters to identify those meters with associated metrics that are abnormal compared with other meters of the set. A postprocessing step can be performed to select meters that have abnormal metrics based on likelihood of bypass versus meters that have abnormal metrics for another reason.

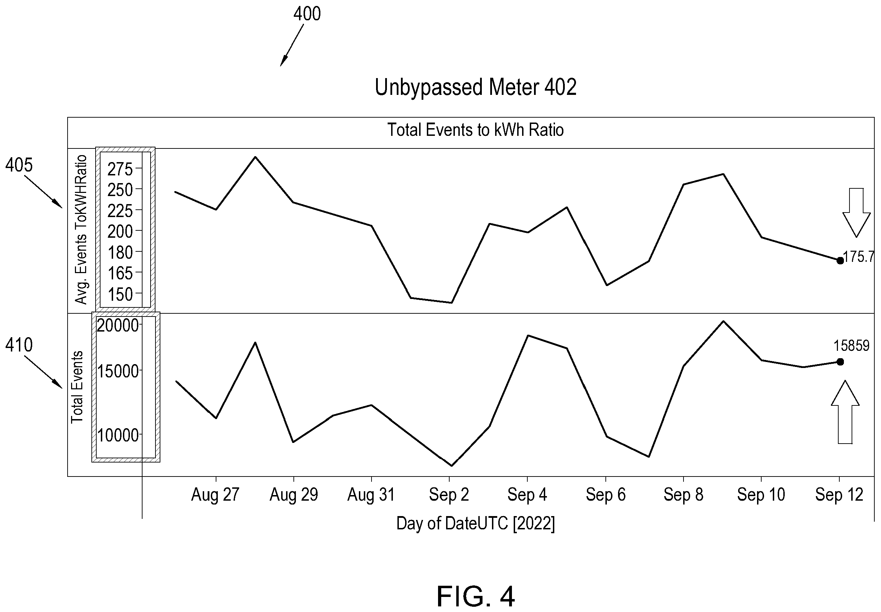

FIG. 4 illustrates an example output 402 for certain metrics for a meter that is not bypassed. In FIG. 4, a graph of a SETER metric 405 is depicted for a series of days (where one day is a reporting interval). SETER metric 405, as depicted, varies within a range between 150 to around 300 (a 2x difference over a period of several weeks). A total count of load switching events metric 410 (TCLSE metric 410) that shows a total count of switching events across the series of days is also depicted. TCLSE metric 410 shows a relatively substantial variation of total load switching events per day, ranging from a few thousand to almost twenty thousand over the course of a few weeks.

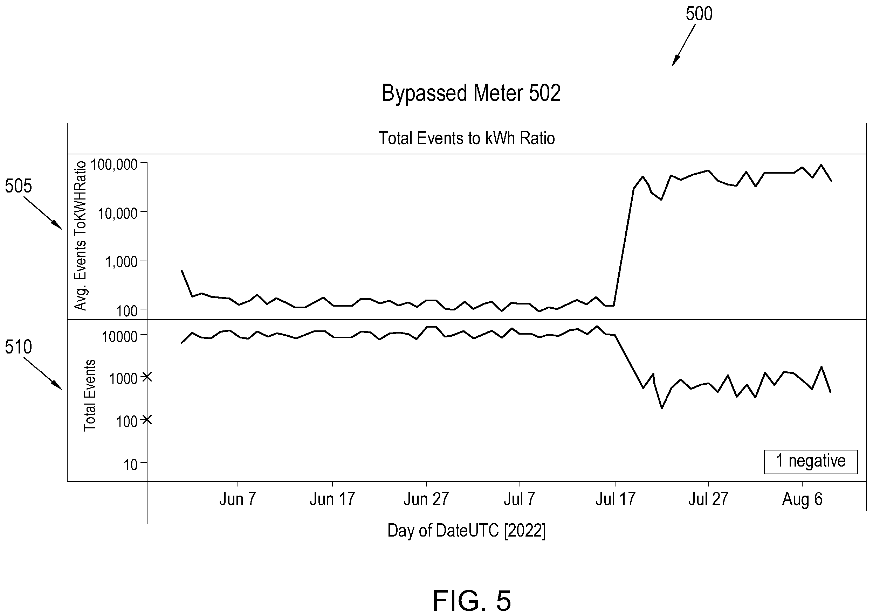

FIG. 5 illustrates an example output 502 for certain metrics for a meter that is bypassed. In FIG. 5, the bypass was installed around July 17, as can be evidenced by a marked increase in a SETER metric 505. As depicted, SETER metric 505 changes by about 100x due to bypass installation, relative to prior values for SETER metric 505, and SETER metric 505 is about 300-600 times larger than SETER metric 405 for the un-bypassed meter of FIG. 4. Such values for SETER metric 505 therefore can be considered abnormal, based on a comparison with prior values of SETER metric 505, and/or based on a comparison with SETER metric 405 for an un-bypassed meter. FIG. 5 also illustrates a large and consistent reduction (about 10x reduction) in a Total Count of Switching Events metric 510 (TCLSE 510). Comparing TCLSE 410 and 510, TCLSE 410 (for the un-bypassed meter) is relatively large, being at least several thousand load switching events a day, and up to twenty thousand events per day, while TCLSE 510 (for the bypassed meter) shows a count generally less than one thousand, and more typically much less. While TCLSE 510 is less than TCLSE 410, a variability around an average of TCLSE 510 is higher than that of TCLSE 410; for example, TCLSE 510 has a range of over 5x between highest and lowest counts, while TCLSE 410 has a range closer to 2x. FIGs. 4 and 5 thus show example qualitative differences between likely bypassed meters and un-bypassed meters.

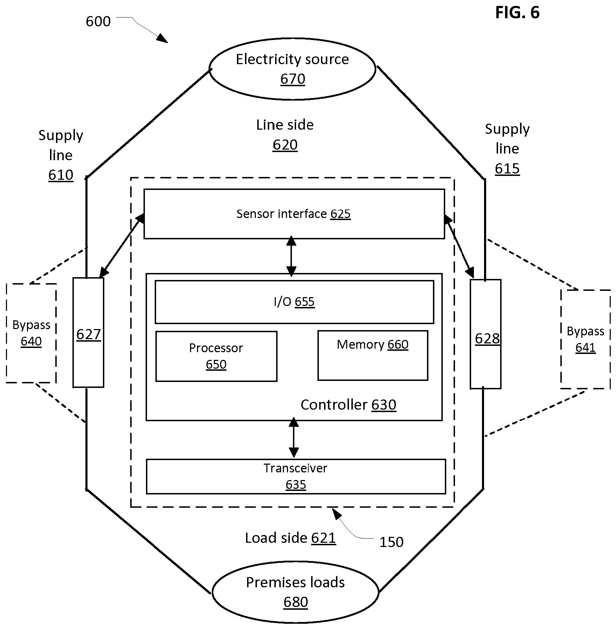

FIG. 6 illustrates an example meter installation 600, according to various embodiments. Meter installation 600 includes, without limitation, meter 150, a line side 620 of meter 150 that couples with electricity source 670 and includes supply line 610 and supply line 615, and a load side 621 of meter 150 that couples with premises loads 680. Meter 150 also couples with sensor subsystem 627 for supply line 610 and with sensor subsystem 628 for supply line 615. Bypass 640 diagrammatically shows that bypass 640 creates a parallel current path around sensor subsystem 627 and bypass 641 diagrammatically shows that bypass 641 creates a parallel path around sensor subsystem 628, so that current flowing in bypass 640 and/or 641 is not sensed by sensor subsystems 627 and 628.

Meter 150 includes, without limitation, sensor interface 625, a controller 630, and a transceiver 635. Sensor interface 625 couples with sensor subsystems 627 and 628. Sensor interface 625 couples with controller 630 and controller 630 couples with transceiver 635. Controller 630 in turn includes, without limitation, I/O 655, processor 650, and memory 660. In some embodiments, controller 630 650 is a microcontroller that includes processor 650 as a core, and also integrates any one or more of I/O 655, some elements of memory 660, such as non-volatile storage for one or more programs of operation, sensor interface 625 and transceiver 635 or portions thereof.

In some embodiments, I/O 655, processor 650 and memory 660 are entirely or partially implemented within one integrated circuit, and/or within one integrated circuit package. In some embodiments, transceiver 635 is integrated with controller 630 and/or with I/O 655, entirely or partially within one integrated circuit and/or within one integrated circuit package (e.g. a media access controller of transceiver 635 can be integrated into a single IC with controller 630 and physical layer circuitry can be in the same package as controller 630, but not on the single IC). In some embodiments, portions of memory 660 are integrated with controller 630 and other portions are within the same package, or located on a circuit board and interfacing with controller 630 via an external memory interface of controller 630. While this disclosure provides example embodiments of these elements of meter 150, any other technically feasible alternative can be employed instead to implement embodiments according to the disclosure. I/O 655 can include serial bus interfaces (e.g., PCle and CXI) that run over electrical or optical physical media as well as general purpose I/O and/or I/O used to implement industrial networking or communication protocols, such as RS-422, and RS-485. Data can be accessed from external to controller 630 via I/O 655, such as via a field service port, and stored in memory 660, from which it is accessed, and vice versa.

During operation, supply line 610 and supply line 615 each carry an electrical current and voltage waveform. Sensor subsystems 627 and 628 measure current and voltage (voltage can be measured with respect to a neutral that is not depicted) on respective supply line 610 and supply line 615 at a measurement interval, such as every second. Any technically feasible mechanism to measure current and voltage can be provided. The measured current and voltage samples are obtained by sensor interface 625. Sensor interface 625 is adapted according to what interface is available on sensor subsystems 627 and 628. For example, sensor subsystems 627 and 628 can have an analog output, and sensor interface 625 would include an analog to digital (A/D) converter to convert, on the measurement interval, the analog output to a stream of digital values. Sensor subsystems 627 and 628 can include registers or a buffer that stores one or more current and/or voltage samples, which are read by sensor interface 625.

Controller 630 receives the voltage and current measurements and stores the voltage and current measurements in memory 660. Processor 650 can execute instructions for a program 662 stored on memory 660 that controls I/O 655 to obtain the voltage and current measurements from sensor interface 625 and stores the measurements in memory 660. In some embodiments, program 662 can use services provided by an embedded operating system (not depicted). In some embodiments, sensor interface 625 is part of I/O 655, such that I/O 655 directly interfaces with sensor subsystems 627 and 628. Processor 650 can produce, under control of program 662, a compressed form of the measured current and/or voltage and store the compressed form in memory 660. For example, a series of current measurements can be stored as difference values, rather than independently representing each value at a required precision. In some embodiments, the measurements can be cryptographically signed, encrypted or otherwise obfuscated while stored.

Controller 630 couples with transceiver 635 for uploading data to meter control center 160, as described herein. Controller 630 can couple with transceiver 635 using I/O 655. Transceiver 635 can operate using wired or wireless connections, including wireless LAN technologies, cellular radio technologies, peer-to-peer, mesh network technologies, and other technically feasible alternatives. It would be understood that transceiver 635 can include combinations of hardware and software that collectively implement physical layer communications, and other communication functionality as needed.

In some embodiments, program 662 computes or determines one or more metrics for use at meter control center 160, including for example, a TCLSE metric, a TMED metric, a SETER metric, and/or a SELC metric according to the disclosure. These determined and/or computed metrics are uploaded by program 662, using transceiver 635, to meter control center 160 for use in determining whether meter 150 is likely bypassed according to any of the embodiments disclosed herein. In some embodiments, meter 150 receives one or more comparison thresholds from meter control center 160, and program 662 executing on processor 650 compares locally computed metrics with corresponding received comparison thresholds and locally determines whether meter 150 is bypassed. In this embodiment, program 662, via transceiver 635, provides a report of this determination to meter control center 160.

If meter 150 is to execute a trained inferencing model, as described with respect to FIG. 3, then controller 630 receives the trained inferencing model via transceiver 635 from meter control center 160. Controller 630 causes the trained inferencing model to be stored in memory 660. In some embodiments, program 662 interfaces, via transceiver 635, with meter control center 160 to receive the trained inferencing model. In some implementations, a structure for the inferencing model is preloaded in memory 660 (e.g., as a portion of program 662), and the trained inferencing model received via transceiver 635 are weights and other configuration information for the model structure. The trained inferencing model is executed on processor 650 (e.g., during execution of program 662) using metrics computed by program 662. Program 662 can store these metrics in and retrieve these metrics from memory 660. In some embodiments, processor 650 includes inferencing acceleration hardware such as an ASIC, FPGA, or DSP that can assist in executing the trained inferencing model, and some portions of computation to be performed during execution of program 662 are performed using such acceleration hardware. In some embodiments, these acceleration elements are integrated within a package or within a single semiconductor substrate with a general purpose processor core that orchestrates the overall operation of meter 150. Meter control center 160 can, from time to time, update program 662.

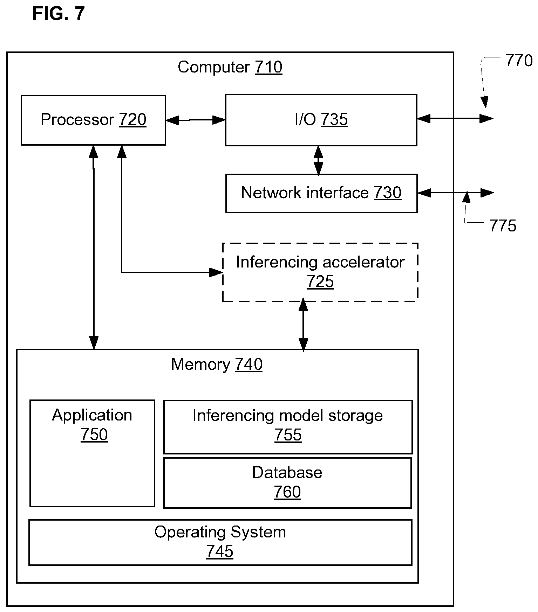

FIG. 7 illustrates an example computer 710 with which methods according to various embodiments can be practiced. Computer 710, includes without limitation, processor 720, optional inferencing accelerators 725, network interface 730, I/O 735, and memory 740. Processor 720 can be and/or include any technically feasible processing device configured to process data and execute program instructions. For example, the processor(s) 720 can include, without limitation, one or more central processing units (CPUs), DSPs, graphics processing units (GPUs), application-specific integrated circuits (ASICs), field-programmable gate arrays (FPGAs), microprocessors, microcontrollers, other types of processing units, and/or a combination of such processing units. Some embodiments provide that a CPU can offload various tasks to FPGAs or DSPs, GPUs or ASICs (not depicted).

Memory 740 includes one or more non-transitory memory elements that store data, including without limitation, application 750, inferencing model(s) 755, database 760 and operating system 745. Memory 740 can be implemented by any combination of technically feasible storage media. For example, memory 740 can include random-access memory (RAM) module(s), solid-state memory unit(s), magnetic storage, and/or other types of memories. In some implementations, memory 740 can be composed of multiple tiers of storage that have different capabilities, such as a bulk storage tier having mass storage capabilities that can be implemented by magnetic and/or solid state storage, a faster bulk storage tier comprising solid-state storage drives, working memories generally comprised of random access memories (such as dynamic random access memory) as well as faster caches that can be composed of static random access memory. Memory management technologies can be built into processor 720 or can otherwise be deployed in computer 710 to move data among the tiers for use in tasks specified by application 750.

Application 750 include program instructions that, when executed by the processor 720, perform any one or more of the computer-based techniques described herein. Application 750 can perform method 200 and/or method 300. In further detail, when executed, operating system 745 provides services to application 750, such as interfaces to I/O 735, inferencing accelerator 725, database 760, and so forth. Application 750 receives reports from meters, such by retrieving data for those reports from database 760, and/or receiving such data via I/O 735. Application 750 generates metrics according to disclosed embodiments, and outputs determinations as to whether the meters, to which the reports pertain, are likely bypassed. These determinations can be stored in database 760 and/or sent via network interface 730 to a utility operations center (e.g., utility operations 170 of FIG. 1). Application 750 can deploy and execute inferencing model(s) from inferencing model storage 755 in order to perform such determinations. These determinations of likelihood of bypass can be stored in memory 740, including in database 760, for later use, such as for training inferencing models or for computing metrics according to the disclosure.

I/O 735 can include serial bus interfaces (e.g., PCle and CXI) that run over electrical or optical physical media 770. Data can be accessed from external to computer 710 via I/O 735 and stored in memory 740, from which it is accessed, and vice versa. Network interface 730 can include an Ethernet interface that operates over electrical or optical physical media 775, and/or a wireless network interface. Network interface 730 also can include interfaces for storage networks. I/O 735 can also function to send data to and receive data from network interface 730. Such data can originate from processor 720 or be destined for processor 720. Received data can include data for meter reports, data describing metrics derived from meter reports, and data describing trained inferencing models. I/O 735 can packetize or otherwise format and transmit such data as appropriate for a particular interface on which such data is sent.

In some embodiments, computer 710 includes, without limitation, a variety of other supporting hardware, including power management hardware, secure boot hardware, a real-time clock (RTC), and other capabilities as can be useful for a given computer or for meter control center 160.

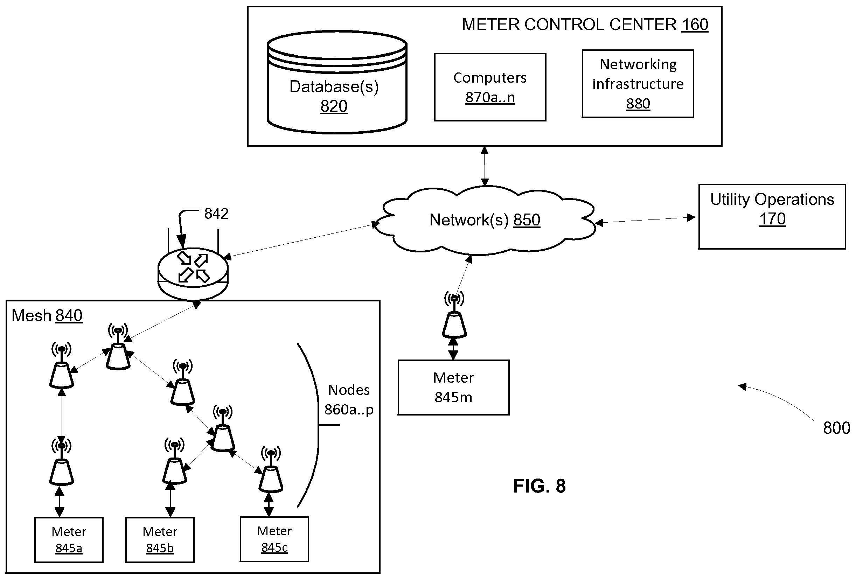

FIG. 8 illustrates aspects of an example utility system 800 according to various embodiments. Utility system 800 includes, without limitation, meter control center 160, utility operations 170, mesh network 840, meters 845a..m and network 850. Meter control center 160 includes, without limitation, database(s) 820, computer(s) 870a..n and networking infrastructure 880.

Database(s) 820 can be implemented using any technically feasible database technology. These databases 820 can store datasets used in embodiments of the disclosure, including, without limitation, data from meter reports, metrics derived from meter reports, information describing outputs of past bypass determinations, training inference models, data visualization programs, and so on. Computers 870a..n can be implemented in accordance with the example of FIG. 7 or by any technically feasible technology. Computer 870a..n can access report data from databases 820 through networking infrastructure 880 and perform processes according to the disclosure to produce metrics, and use those metrics in making determinations whether any of the meters associated with the processed reports are likely bypassed, according to embodiments disclosed herein. Networking infrastructure 880 can be implemented by any technically feasible approach, which can include a mixture of hardware resources, including switches and routers that use physical or optical interconnects, software-defined networks, virtual networks, firewalls and other technology. Networking infrastructure 880 interfaces with network 850, for communication with meters 845a..m and utility operations 170. In some embodiments, subsets of computers 850a..n perform different tasks. One subset can communicate with meters 845a..m, including ingesting reports from meters 845a...m and storing such reports in databases 820, while another subset can make determinations of likelihood of existence of meter bypasses using the reports, including performing computations in accordance with disclosed embodiments. Meters 845a..m represent a plurality of meters that are implemented consistently with the implementation of meter 150 according to the disclosure.

A mesh network 840 is depicted as communicating with network(s) 850 via a gateway 842. Nodes 860a-860p are networked devices within mesh network 840. Nodes 860a-860p can include communication and networking functionality, such as any of a cellular modem, Bluetooth^{®}, WiFi^{®} and other short-range communication technologies. Any technically feasible implementation of a peer-to-peer, mesh or other networking technology can be used to provide communication between meters 845a..845c and meter control center 160. Communication can be uni-directional, so that meters 845a..845c can upload reports but do not receive communications from control center 160, or bi-directional (such as to receive program updates and/or inferencing models as described with respect to FIG. 6). A meter 845m communicates with meter control center 160 via network(s) 850. Meter 845m exemplifies an embodiment where a meter can have a full networking capability, such as having a wireless LAN or Ethernet capability and a full TCP/IP network stack.

At least one technical advantage of the disclosed techniques is that, with the disclosed techniques, the possible existence of a bypass on an electrical meter can be determined or inferred based on data that is already collected for purposes of measuring electrical energy consumption and corresponding billing. In addition, as more data is collected and as feedback is obtained as to the accuracy of the meter bypass determinations and/or inferences, the accuracy of the determinations and/or inferences can be improved. The disclosed techniques further reduce the need for random or systemic meter audits or other visual inspections and are also less intrusive to utility customers.

The descriptions of the various embodiments have been presented for purposes of illustration, but are not intended to be exhaustive or limited to the embodiments disclosed. Many modifications and variations will be apparent to those of ordinary skill in the art without departing from the scope of the described embodiments.

Aspects of the present embodiments may be embodied as a system, method or computer program product. Accordingly, aspects of the present disclosure may take the form of an entirely hardware embodiment, an entirely software embodiment (including firmware, resident software, micro-code, etc.) or an embodiment combining software and hardware aspects that may all generally be referred to herein as a "module," a "system," or a "computer." In addition, any hardware and/or software technique, process, function, component, engine, module, or system described in the present disclosure may be implemented as a circuit or set of circuits. Furthermore, aspects of the present disclosure may take the form of a computer program product embodied in one or more computer readable medium(s) having computer readable program code embodied thereon.

Any combination of one or more computer readable medium(s) may be utilized. The computer readable medium may be a computer readable signal medium or a computer readable storage medium. A computer readable storage medium may be, for example, but not limited to, an electronic, magnetic, optical, electromagnetic, infrared, or semiconductor system, apparatus, or device, or any suitable combination of the foregoing. More specific examples (a non-exhaustive list) of the computer readable storage medium would include the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of this document, a computer readable storage medium may be any tangible medium that can contain or store a program for use by or in connection with an instruction execution system, apparatus, or device.

Aspects of the present disclosure are described above with reference to flowchart illustrations and/or block diagrams of methods, apparatus (systems) and computer program products according to embodiments of the disclosure. It will be understood that each block of the flowchart illustrations and/or block diagrams, and combinations of blocks in the flowchart illustrations and/or block diagrams, can be implemented by computer program instructions. These computer program instructions may be provided to a processor of a general-purpose computer, special purpose computer, or other programmable data processing apparatus to produce a machine. The instructions, when executed via the processor of the computer or other programmable data processing apparatus, enable the implementation of the functions/acts specified in the flowchart and/or block diagram block or blocks. Such processors may be, without limitation, general purpose processors, special-purpose processors, application-specific processors, or field-programmable gate arrays.

The flowchart and block diagrams in the figures illustrate the architecture, functionality, and operation of possible implementations of systems, methods and computer program products according to various embodiments of the present disclosure. In this regard, each block in the flowchart or block diagrams may represent a module, segment, or portion of code, which comprises one or more executable instructions for implementing the specified logical function(s). It should also be noted that, in some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts, or combinations of special purpose hardware and computer instructions.

While the preceding is directed to embodiments of the present disclosure, other and further embodiments of the disclosure may be devised without departing from the basic scope thereof, and the scope thereof is determined by the claims that follow.

## Claims

1. A method comprising:
obtaining, by a computer (710), a count of load switching events at a location over a period of time, the load switching events corresponding to respective changes of current flow in one or more electrical supply lines (610,615) of a meter (150) at the location;
obtaining, by the computer, a measure of an amount of electricity consumption for the location over the period of time; and
determining, by the computer, that the meter has likely been bypassed, based on the count of the load switching events and the measured amount of electricity consumption.

2. The method of claim 1, further comprising, in response to determining that the meter has likely been bypassed, reporting, by the computer, that the meter has likely been bypassed.

3. The method of claim 1 or 2, wherein the obtaining the count of load switching events comprises counting a load switching event in response to determining that a difference in current flow between two or more consecutive measurements of current flow for the one or electrical supply lines is greater than a threshold.

4. The method of any one of claims 1 to 3, wherein determining that the meter has likely been bypassed comprises:
determining a first ratio between the count of load switching events at the location over the period of time and the measured amount of electricity consumption for the location over the period of time; and
determining that the meter has been bypassed based on the first ratio.

5. The method of any one of claims 1 to 4, wherein the computer is disposed on a cellular tower located in a same geographic region as the meter.

6. The method of any one of claims 1 to 5, further comprising:
determining, by the computer, a largest current delivered through the meter over the period of time;
wherein determining that the meter has likely been bypassed comprises determining that the meter is more likely to be bypassed in response to a ratio of the count of load switching events to the largest current delivered over the period of time being high relative to a ratio threshold.

7. The method of claim 6, further comprising
obtaining, by the computer, respective counts of load switching events at a plurality of locations over the period of time, the load switching events corresponding to respective changes of current flow in one or more electrical supply lines of respective electrical meters at the plurality of locations;
obtaining, by the computer, respective measures of electricity consumption for the plurality of locations; and
establishing, based on the respective counts and respective measures of electricity consumption, the ratio threshold.

8. The method of any one of claims 1 to 7, wherein determining that the meter has likely been bypassed is further based on an output of an inferencing model trained using a dataset comprising respective counts of load switching events of electricity consumption and total energy consumption, for a plurality of time periods for both a plurality of bypassed meters and for a plurality of un-bypassed meters.

9. The method of claim 8, wherein the dataset used to train the inferencing model further comprises respective ratios between counts of load switching events and corresponding measures of the amount of electricity consumption for the plurality of time periods, for both the plurality of bypassed meters and for the plurality of un-bypassed meters.

10. The method of any one of claims 1 to 8, wherein determining that the meter has likely been bypassed further comprises determining a measure of variation of counts of load switching events for the meter for a plurality of periods of time, and determining that the meter is more likely to have been bypassed when the measure of variation is higher than a variation threshold.

11. The method of any one of claims 1 to 10, wherein determining that the meter has likely been bypassed comprises determining that count of the load switching events is abnormal relative to a baseline.

12. The method of any one of claims 1 to 11, further comprising:
determining a largest measured current through the meter during the period of time; and
determining that the meter has likely been bypassed further comprises determining that the meter is more likely to be bypassed if the largest measured current is smaller than a baseline.

13. The method of claim 1, wherein determining that the meter has likely been bypassed is further based on an output of an inferencing model trained on data from at least one of prior reports from the meter or reports from other meters in a same geographical region.

14. One or more non-transitory computer-readable media storing instructions which, when executed by one or more processors, cause the one or more processors to perform the method of any one of claims 1 to 13.

15. An apparatus comprising:
a network interface (730) configured to couple the apparatus to a meter (150);
one or more processors; and
a memory system storing executable instructions that, when executed by the one or more processors, cause the one or more processors to perform the method of any one of claims 1 to 13.

## Patentansprüche

1. Verfahren, umfassend:
Erhalten, durch einen Computer (710), einer Anzahl von Lastschaltereignissen an einem Ort über einen Zeitraum, wobei die Lastschaltereignisse jeweiligen Änderungen eines Stromflusses in einer oder mehreren Stromversorgungsleitungen (610, 615) eines Messgeräts (150) an dem Ort entsprechen;
Erhalten, durch den Computer, einer Messgröße eines Stromverbrauchsbetrags für den Ort über den Zeitraum; und
Bestimmen, durch den Computer, dass das Messgerät wahrscheinlich umgangen wurde, basierend auf der Anzahl der Lastschaltereignisse und dem gemessenen Stromverbrauchsbetrag.

2. Verfahren nach Anspruch 1, ferner umfassend, als Reaktion auf das Bestimmen, dass das Messgerät wahrscheinlich umgangen wurde, Berichten, durch den Computer, dass das Messgerät wahrscheinlich umgangen wurde.

3. Verfahren nach Anspruch 1 oder 2, wobei das Erhalten der Anzahl von Lastschaltereignissen Zählen eines Lastschaltereignisses als Reaktion auf ein Bestimmen, dass eine Differenz des Stromflusses zwischen zwei oder mehr aufeinanderfolgenden Messungen des Stromflusses für die eine oder die mehreren Stromversorgungsleitungen größer als ein Schwellenwert ist, umfasst.

4. Verfahren nach einem der Ansprüche 1 bis 3, wobei das Bestimmen, dass das Messgerät wahrscheinlich umgangen wurde, Folgendes umfasst:
Bestimmen eines ersten Verhältnisses zwischen der Anzahl von Lastschaltereignissen an dem Ort über den Zeitraum und dem gemessenen Stromverbrauchsbetrag für den Ort über den Zeitraum; und
Bestimmen, dass das Messgerät umgangen wurde, basierend auf dem ersten Verhältnis.

5. Verfahren nach einem der Ansprüche 1 bis 4, wobei der Computer auf einem Mobilfunkturm angeordnet ist, der sich in einem gleichen geografischen Gebiet wie das Messgerät befindet.

6. Verfahren nach einem der Ansprüche 1 bis 5, ferner umfassend:
Bestimmen, durch den Computer, eines größten Stroms, der durch das Messgerät über den Zeitraum geliefert wurde;
wobei das Bestimmen, dass das Messgerät wahrscheinlich umgangen wurde, Bestimmen, dass die Wahrscheinlichkeit höher ist, dass das Messgerät umgangen wird, als Reaktion darauf, dass ein Verhältnis der Anzahl von Lastschaltereignissen zu dem über den Zeitraum gelieferten größten Strom relativ zu einem Verhältnisschwellenwert hoch ist, umfasst.

7. Verfahren nach Anspruch 6, ferner umfassend
Erhalten, durch den Computer, jeweiliger Anzahlen von Lastschaltereignissen an mehreren Orten über den Zeitraum, wobei die Lastschaltereignisse jeweiligen Änderungen des Stromflusses in einer oder mehreren Stromversorgungsleitungen jeweiliger Strommessgeräte an den mehreren Orten entsprechen;
Erhalten, durch den Computer, jeweiliger Messungen des Stromverbrauchs für die mehreren Orte; und
Festlegen des Verhältnisschwellenwerts basierend auf den jeweiligen Anzahlen und jeweiligen Messgrößen des Stromverbrauchs.

8. Verfahren nach einem der Ansprüche 1 bis 7, wobei das Bestimmen, dass das Messgerät wahrscheinlich umgangen wurde, ferner auf einer Ausgabe eines Inferenzmodells basiert, das unter Verwendung eines Datensatzes trainiert wird, der jeweilige Anzahlen von Lastschaltereignissen des Stromverbrauchs und einen Gesamtenergieverbrauch für mehrere Zeiträume sowohl für mehrere umgangene Messgeräte als auch für mehrere nicht umgangene Messgeräte umfasst.

9. Verfahren nach Anspruch 8, wobei der Datensatz, der zum Trainieren des Inferenzmodells verwendet wird, ferner jeweilige Verhältnisse zwischen Anzahlen von Lastschaltereignissen und entsprechenden Messgrößen des Stromverbrauchsbetrags für die mehreren Zeiträume sowohl für die mehreren überbrückten Messgeräte als auch für die mehreren nicht überbrückten Messgeräte umfasst.

10. Verfahren nach einem der Ansprüche 1 bis 8, wobei das Bestimmen, dass das Messgerät wahrscheinlich umgangen wurde, ferner Bestimmen einer Messgröße einer Schwankung der Anzahlen von Lastschaltereignissen für das Messgerät für mehrere Zeiträume und Bestimmen, dass die Wahrscheinlichkeit höher ist, dass das Messgerät umgangen wird, wenn die Messgröße der Schwankung höher als ein Schwankungsschwellenwert ist, umfasst.

11. Verfahren nach einem der Ansprüche 1 bis 10, wobei das Bestimmen, dass das Messgerät wahrscheinlich umgangen wurde, Bestimmen, dass die Anzahl der Lastschaltereignisse relativ zu einem Basiswert anormal ist, umfasst.

12. Verfahren nach einem der Ansprüche 1 bis 11, ferner umfassend:
Bestimmen eines größten gemessenen Stroms durch das Messgerät während des Zeitraums; und
wobei das Bestimmen, dass das Messgerät wahrscheinlich umgangen wurde, ferner Bestimmen, dass die Wahrscheinlichkeit höher ist, dass das Messgerät umgangen wird, wenn der größte gemessene Strom kleiner als ein Basiswert ist, umfasst.

13. Verfahren nach Anspruch 1, wobei das Bestimmen, dass das Messgerät wahrscheinlich umgangen wurde, ferner auf einer Ausgabe eines Inferenzmodells basiert, das mit Daten von früheren Berichten von dem Messgerät und/oder Berichten von anderen Messgeräten in einem gleichen geografischen Gebiet trainiert wird.

14. Ein oder mehrere nichtflüchtige computerlesbare Medien, die Anweisungen speichern, die bei Ausführung durch einen oder mehrere Prozessoren den einen oder die mehreren Prozessoren veranlassen, das Verfahren nach einem der Ansprüche 1 bis 13 durchzuführen.

15. Einrichtung, umfassend:
eine Netzwerkschnittstelle (730), die dazu ausgelegt ist, die Einrichtung mit einem Messgerät (150) zu koppeln;
einen oder mehrere Prozessoren; und
ein Speichersystem, das ausführbare Anweisungen speichert, die bei Ausführung durch den einen oder die mehrere Prozessoren den einen oder die mehreren Prozessoren veranlassen, das Verfahren nach einem der Ansprüche 1 bis 13 durchzuführen.

## Revendications

1. Procédé comprenant les étapes suivantes :
obtenir, par un ordinateur (710), un comptage d'événements de commutation de charge, à un emplacement, pendant une période de temps, les événements de commutation de charge correspondant à des changements respectifs de courant circulant dans une ou plusieurs lignes d'alimentation électrique (610, 615) d'un compteur (150) au niveau de l'emplacement ;
obtenir, par l'ordinateur, une mesure de la consommation d'électricité de l'emplacement sur la période de temps ; et
déterminer, par l'ordinateur, que le compteur a probablement été contourné, sur la base du décompte des événements de commutation de charge et de la consommation d'électricité mesurée.

2. Procédé selon la revendication 1, comprenant en outre, en réponse à la détermination du fait que le compteur a vraisemblablement été contourné, de signaler, par l'ordinateur, que le compteur a vraisemblablement été contourné.

3. Procédé selon la revendication 1 ou la revendication 2, dans lequel l'obtention du comptage d'événements de commutation de charge comprend le comptage d'un événement de commutation de charge en réponse à la détermination qu'une différence de circulation de courant entre deux, ou davantage, mesures consécutives de circulation de courant pour la ligne d'alimentation électrique est supérieure à un seuil.

4. Procédé selon l'une quelconque des revendications 1 à 3, dans lequel la détermination que le compteur a vraisemblablement été contourné comprend les étapes suivantes :
déterminer un premier rapport entre le comptage d'événements de commutation de charge au niveau de l'emplacement pendant la période de temps et la consommation d'électricité mesurée pour l'emplacement sur la période de temps ; et
déterminer que le compteur a été contourné sur la base du premier rapport.

5. Procédé selon l'une quelconque des revendications 1 à 4, dans lequel l'ordinateur est disposé sur une tour cellulaire située dans une même région géographique que le compteur.

6. Procédé selon l'une quelconque des revendications 1 à 5, le procédé comprenant en outre les étapes suivantes :
déterminer, par l'ordinateur, le plus grand courant délivré à travers le compteur sur la période de temps ;
où la détermination du fait que le compteur a vraisemblablement été contourné comprend de déterminer que le compteur est d'autant plus susceptible d'être contourné qu'un rapport entre le compte d'événements de commutation de charge et le courant le plus important délivré sur la période de temps est élevé par rapport à un seuil de rapport.

7. Procédé selon la revendication 6, comprenant en outre les étapes suivantes
obtenir, par l'ordinateur, les comptages respectifs d'événements de commutation de charge à une pluralité d'emplacements pendant la période de temps, les événements de commutation de charge correspondant à des changements respectifs de circulation de courant dans une ou plusieurs lignes d'alimentation électrique de compteurs électriques respectifs au niveau de la pluralité d'emplacements ;
obtenir, par l'ordinateur, des mesures respectives de la consommation électrique pour la pluralité d'emplacements ; et
établir, sur la base des comptages respectifs et des mesures respectives de la consommation d'électricité, le seuil de rapport.

8. Procédé selon l'une quelconque des revendications 1 à 7, dans lequel la détermination du fait que le compteur a vraisemblablement été contourné est en outre basée sur une sortie d'un modèle d'inférence formé en utilisant un ensemble de données comprenant des comptages respectifs d'événements de commutation de charge de consommation d'électricité et de consommation d'énergie totale, pendant une pluralité de périodes de temps pour une pluralité de compteurs contournés et pour une pluralité de compteurs non contournés.

9. Procédé selon la revendication 8, dans lequel l'ensemble de données utilisé pour former le modèle d'inférence comprend en outre des rapports respectifs entre des comptages d'événements de commutation de charge et des mesures correspondantes de la quantité de consommation d'électricité pour la pluralité de périodes de temps, à la fois pour la pluralité de compteurs contournés et pour la pluralité de compteurs non contournés.

10. Procédé selon l'une quelconque des revendications 1 à 8, dans lequel la détermination du fait que le compteur a probablement été contourné comprend en outre de déterminer une mesure de variation des comptages d'événements de commutation de charge pour le compteur pendant une pluralité de périodes de temps, et de déterminer que le compteur d'autant plus susceptible d'avoir été contourné que la mesure de variation est supérieure à un seuil de variation.

11. Procédé selon l'une quelconque des revendications 1 à 10, dans lequel la détermination du fait que le compteur a probablement été contourné comprend de déterminer que le comptage des événements de commutation de charge est anormal par rapport à une ligne de base.

12. Procédé selon l'une quelconque des revendications 1 à 11, le procédé comprenant en outre les étapes suivantes :
déterminer le courant mesuré le plus important dans le compteur pendant la période de temps ; et
déterminer que le compteur a probablement été contourné comprend en outre de déterminer que le compteur est d'autant plus susceptible d'avoir été contourné que le courant mesuré le plus important est inférieur à une ligne de base.

13. Procédé selon la revendication 1, dans lequel la détermination du fait que le compteur a vraisemblablement été contourné est en outre basée sur une sortie d'un modèle d'inférence formé sur des données provenant d'au moins l'un des rapports antérieurs provenant du compteur ou des rapports provenant d'autres compteurs dans une même région géographique.

14. Un ou plusieurs supports non transitoires lisibles par ordinateur stockant des instructions qui, lorsqu'elles sont exécutées par un ou plusieurs processeurs, amènent les un ou plusieurs processeurs à réaliser le procédé selon l'une quelconque des revendications 1 à 13.

15. Appareil comprenant :
une interface réseau (730) configurée pour coupler l'appareil à un compteur (150) ;
un ou plusieurs processeurs ; et
une mémoire système stockant des instructions exécutables qui, lorsqu'elles sont exécutées par les un ou plusieurs processeurs, amènent les un ou plusieurs processeurs à réaliser le procédé selon l'une quelconque des revendications 1 à 13.
